# EUROPÄISCHE PATENTANMELDUNG

(11) **EP 3 296 751 A1**
(43) Veröffentlichungstag der Anmeldung: **21.03.2018**
(21) Anmeldenummer: 16189801.0
(22) Anmeldetag: 20.09.2016
(51) Int. Cl.: G01R 11/04, G01R 1/04

(54) **ELEKTRIZITÄTSZÄHLER**

(71) Anmelder: Semax AG, 6330 Cham (CH)
(72) Erfinder: Fischer, Severin, CH-6300 Zug (CH)
(74) Vertreter: Schirbach, Marcel

(57) **Zusammenfassung**

Bei einem erfindungsgemässen Elektrizitätszähler (1), der mit mindestens einer Strom-Spannungsmesseinheit (2) und daran unmittelbar angeschlossenen, elektrischen Leitern (3a, 3b) ausgestattet ist, erstrecken sich diese Leiter (3a, 3b) bis zu einem Klemmenblockgehäuseteil (6) und ferner durch diesen Klemmenblockgehäuseteil (6) hindurch und überragen denselben derart, dass diese Leiter (3a, 3b) unmittelbar an einer Zählersteckklemme (4) einer Hausinstallation anschliessbar sind.

## Beschreibung

Die vorliegende Erfindung fällt in den Bereich der Hausanschlusstechnik; sie betrifft einen Elektrizitätszähler gemäss dem Oberbegriff des Anspruchs 1.

### Stand der Technik

Elektrizitätszähler zur Messung des elektrischen Energieverbrauchs sind für die Hausanschlusstechnik weitläufig bekannt. In der DE 102014101067 B3 ist ein konventioneller Elektrizitätszähler gezeigt, der verschraubbare Phasenanschlüsse für den Anschluss von Phasenleitungen eines Verbrauchers an einem Klemmenblock aufweist.

Aus der DE 22 56 373 ist ebenfalls ein Elektrizitätszähler mit Klemmenblock bekannt; der hier vorliegende Klemmenblock ist in einem Klemmenblockgehäuseteil untergebracht und in einem Inneren eines Zählergehäuses mit einer Anzahl Leiter mit mindestens einer Strom-Spannungsmesseinheit verbunden; ausgangsseitig weist dieser Klemmenblock verschraubte Zähleranschlussstiften (rund oder eckig) zwecks standardisierter Montage des Elektrizitätszählers durch Einstecken in vormontierte Zählersteckklemmen einer Hausinstallation an einem Zählerbrett auf. An diesen Zählersteckklemmen sind einseitig die Phasenleitungen eines Verbrauchers vorgängig verschraubt und an der anderen Seite sind Zählersteckplätze für die oben erwähnten Zähleranschlussstifte vorgesehen. Derartige Zählersteckklemmen bieten den Vorteil einer einfachen Montage des Elektrizitätszählers, da dieser lediglich mit den aus dem Klemmenblock herausragenden Zähleranschlussstiften gleichzeitig mit allen Anschlüssen in die Zählersteckklemme einführbar und verschraubbar ist. Ferner erlaubt eine derartige Installation mittels Zähleranschlussstiften und Zählersteckklemmen einen einfachen und raschen Zähleraustausch im Falle eines Wechsels des Energieanbieters.

Als Nachteilig an dieser Installationsvariante könnte hingegen der Aufwand für die Verschraubung aller Zähleranschlussstifte am Klemmenblock und die Zähleranschlussstifte selbst ins Feld geführt werden, da nicht nur der Klemmenblock selbst mit entsprechenden Schraub- oder Federklemmen versehen sein muss, sondern darüber hinaus auch die Zählersteckklemmen.

### Darstellung der Erfindung

Es ist deshalb Aufgabe der vorliegenden Erfindung, einen Elektrizitätszähler mit derart weiterzubilden, dass beim Einsatz einer standardisierten Montage dieses Elektrizitätszählers mit einem Klemmenblockgehäuseteil an einer Zählersteckklemme im Vergleich zu den bekannten Ausführungsformen eine einfachere Montage ermöglicht wird und dabei der Montageaufwand deutlich verringert werden kann.

Die der Erfindung für den Elektrizitätszähler zugrundeliegende Aufgabe wird gelöst durch die Merkmale des Anspruchs 1; die diesen Erfindungsgedanken weiterbildenden Merkmale sind jeweils Gegenstand der Unteransprüche 2 bis 6.

Der Kern der Erfindung ist darin zu sehen, dass der erfindungsgemässe Elektrizitätszähler mit mindestens einer Strom-Spannungsmesseinheit und daran unmittelbar angeschlossenen elektrischen Leitern derart ausgestaltet ist, dass diese elektrischen Leiter aus einem Zählergehäuse für den Elektrizitätszähler in ein Klemmengehäuseteil hineinragen, dieses Klemmengehäuseteil vollständig durchdringen und zudem soweit überragen, dass diese elektrischen Leiter unmittelbar an eine Zählersteckklemme anschliessbar sind.

Der wesentliche Vorteil des Elektrizitätszählers gemäss der Erfindung ist darin zu sehen, dass er an standardisierten Hausinstallationen einsetzbar ist, bei welchen Zählersteckklemmen an einem Zählerbrett zum Einsatz gelangen. Derartige -heute zusehends übliche- Hausinstallationen geben einerseits die Verschraubungspunkte oder Raststellen für einen Elektrizitätszähler vor und andererseits den Abstand von diesen Befestigungspunkten zu den Zähleranschlussklemmen, das heisst konkret, den Abstand zwischen dem Klemmenblockgehäuseteil und den Zähleranschlussklemmen. Mit Vorteil erfüllt der erfindungsgemässe Elektrizitätszähler die geometrischen Bedingungen für eine standardisierte Montage am Zählerbrett und er weist zudem unmittelbar die Anschlüsse für die Zähleranschlussklemmen in Form der durch das Klemmenblockgehäuseteil hindurchragenden Leiter auf, die direkt mit der Anzahl Strom-Spannungsmesseinheiten verbunden sind.

Als vorteilhaft ist ebenfalls hervorzuheben, dass der neue Elektrizitätszähler zwar ein Klemmenblockgehäuseteil aufweist, dieses aber nicht mit Schraub- und/oder Federklemmen bestückt werden muss, da die von den Strom-Spannungsmesseinheiten abgehenden Leiter direkt und vollständig durch das Klemmenblockgehäuseteil verlaufen, was zu einer ökonomischeren Herstellung beiträgt; zum einen können nicht nur die besagten Klemmen im Klemmenblockgehäuseteil eingespart werden, sondern darüber hinaus auch die Produktionszeit und die Montagezeit gegenüber herkömmlichen Elektrizitätszählern mit vollständigem Klemmenblock verkürzt werden.

In dieser Ausführungsform des erfindungsgemässen Elektrizitätszählers kann von einer universellen Einsetzbarkeit desselben gesprochen werden; es besteht nämlich die Möglichkeit, diesen Elektrizitätszähler unmittelbar über die mit den Strom-Spannungsmesseinheiten verbundenen Leitern an Zählersteckklemmen anzuschliessen und zudem könnte dieser Elektrizitätszähler auch mit seinem Klemmenblockgehäuseteil konventionell an Phasenanschlüsse eines Verbrauchers -frei von einer Zählersteckklemme- angeschlossen werden, sofern der Klemmenblockgehäuseteil mit entsprechenden Schraub- und/oder Federklemmen versehen würde.

Besonders vorteilhafte Ausführungsformen des vorliegenden erfindungsgemässen Elektrizitätszählers sehen vor, dass die unmittelbar mit der Strom-Spannungsmesseinheit verbundenen Leiter als Stanzteile oder als Stanz-Biegeteile gefertigt sind, wobei die Leiter als Stanz-Biegeteile an ihren der Strom-Spannungsmesseinheit abgewandten Enden umgebogen sind.

Eine weitere vorteilhafte Ausführungsform der Erfindung sieht vor, dass die mit der Strom-Spannungsmesseinheit verbundenen Leiter aus einem ersten und einem zweiten Teilleiter ausgebildet sind, wobei der erste Teilleiter als Stanzteil gefertigt ist und der zweite Teilleiter als ein Zähleranschlussstift mit dem ersten Teilleiter eine Lötverbindung, eine Schweissverbindung, einen Nietverbindung oder eine Schraubverbindung aufweist; wahlweise können dabei die zweiten Teilleiter einen runden oder einen viereckigen Querschnitt aufweisen.

Ferner zeichnet sich eine weitere vorteilhafte Ausführungsform des Elektrizitätszählers gemäss der Erfindung dadurch aus, dass die Leiter mindestens eine Biegestelle, einen hier so bezeichneten Leitersprung mit Anschlagkanten und/oder eine Nut aufweisen, wobei diese Biegestelle, dieser Leitersprung und/oder diese Nut zwecks Aufnahme mechanischer Kräfte formschlüssig an einer Gehäusewandung des Zählergehäuses bzw. des Klemmenblockgehäuseteils abstützbar angeordnet ist.

### Kurze Beschreibung der Zeichnungen

Im Folgenden wird die Erfindung anhand von Figuren beispielhaft erläutert. Gleiche Gegenstände sind in den Figuren grundsätzlich mit gleichen Bezugszeichen versehen. An dieser Stelle wird darauf hingewiesen, dass die Figuren keinerlei einschränkende Wirkung auf den Erfindungsgegenstand haben, sondern lediglich mögliche Ausführungsformen des Erfindungsgedankens darstellen.

Es zeigen rein schematisch die
- Fig. 1: einen erfindungsgemässen Elektrizitätszähler;
- Fig. 2: ein Klemmenblockgehäuseteil des Elektrizitätszählers;
- Fig. 3: eine Strom-Spannungsesseinheit des Elektrizitätszählers mit daran unmittelbar angeschlossenen Leitern;
- Fig. 4: eine Zählersteckklemme für den Elektrizitätszähler;
- Fig. 5: eine weitere Ausführungsform der Strom-Spannungsesseinheit des Elektrizitätszählers mit daran unmittelbar angeschlossenen Leitern;
- Fig. 6: die elektrischen Leiter nach Fig. 5 in einem Klemmenblockgehäuseteil;
- Fig. 7: das Klemmenblockgehäuseteil nach Fig. 6 an dem Elektrizitätszähler;
- Fig. 8: eine Ausführungsform der elektrischen Leiter für die Strom-Spannungsmesseinheit;
- Fig. 9: eine Schnittdarstellung durch das Klemmenblockgehäuseteil des Elektrizitätszählers;
- Fig. 10: eine weitere Schnittdarstellung durch das Klemmenblockgehäuseteil des Elektrizitätszählers;
- Fig. 11: noch eine weitere Schnittdarstellung durch das Klemmenblockgehäuseteil des Elektrizitätszählers;
- Fig. 12: Ausführungsformen der elektrischen Leiter für die Strom-Spannungsmesseinheit.

### Wege zur Ausführung der Erfindung

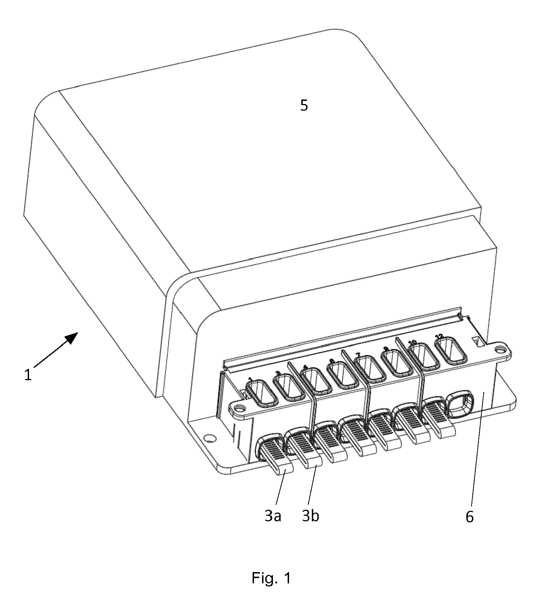

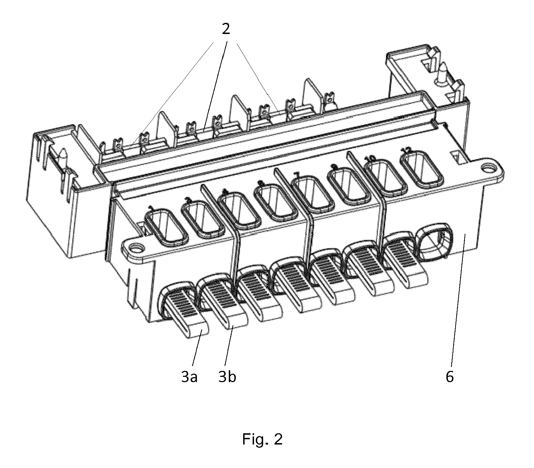

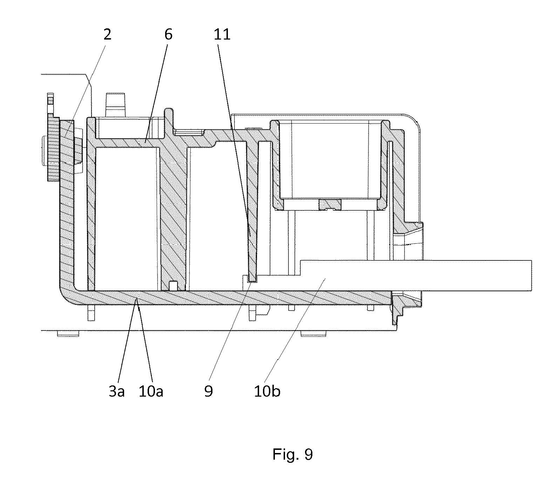

Fig. 1 zeigt einen erfindungsgemässen Elektrizitätszähler 1 mit einem Zählergehäuse 5 und einem Klemmenblockgehäuseteil 6, aus welchem elektrische Leiter 3a, 3b für den Anschluss an eine -hier nicht näher dargestellte- Hausinstallation herausragen. Diese Leiter 3a, 3b führen unmittelbar, wie in perspektivischen Draufsicht auf den Klemmenblockgehäuseteil 6 in Fig. 2 gezeigt, zu einer Strom-Spannungsmesseinheit 2, mit der der Energieverbrauch eines Verbrauchers messbar ist. Wie im Folgenden anhand der Schnittdarstellungen des Klemmenblockgehäuseteils 6 in den Fig. 9 bis 11 zu erläutern sein wird, sind die aus diesem Klemmenblockgehäuseteil 6 herausragenden Leiter 3a, 3b unmittelbar mit der Strom-Spannungsmesseinheit 2 verbunden.

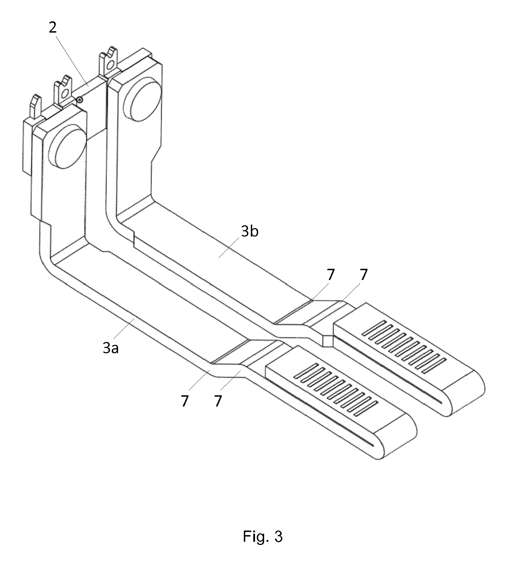

In Fig. 3 ist in perspektivischer Draufsicht eine Ausführungsform der Leiter 3a, 3b gezeigt, die mit der Strom-Spannungsmesseinheit 2 unmittelbar verbunden sind. Die hier zum Einsatz gelangenden Leiter 3a, 3b sind als Stanz-Biegeteile ausgefertigt, wobei die Leiter 3a, 3b an ihren der Strom-Spannungsmesseinheit 2 abgewandten Seite umgebogen sind, um die Querschnitte der Leiter 3a, 3b in diesem Bereich zu vergrössern. Ferner weisen die Leiter 3a, 3b eine Anzahl Biegestellen 7 auf, die -wie im Folgenden noch darzulegen sein wird- formschlüssige Verbindungen mit Gehäusewandungen 11 des Klemmenblockgehäuseteils 6 und/oder des Zählergehäuses 5 eingehen, zwecks Abstützung der Leiter 3a, 3b.

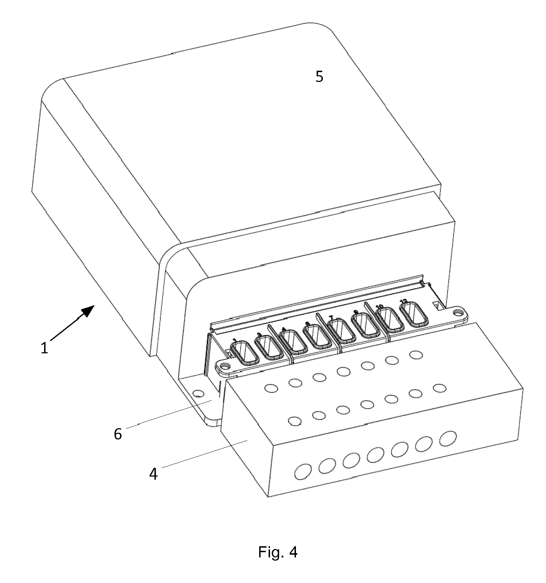

Fig. 4 zeigt den erfindungsgemässen Elektrizitätszähler 1 angeschlossen an einer Zählersteckklemme 4. Solche Zählersteckklemmen 4 sind üblicherweise vorgängig an Zählerbrettern (hier nicht näher gezeigt) angeordnet, um Elektrizitätszähler 1 lediglich durch Einstecken installieren zu können. Eine solche Installation erlaubt eine einfache und rasche Montage und gegebenenfalls Demontage eines Elektrizitätszählers, da die Leiter 3a, 3b lediglich in die vormontierte Zählersteckklemme 4 eingesetzt werden müssen. Die Phasenleitungen (nicht dargestellt) zu einem Verbraucher werden einmalig und vorgängig in der Zählersteckklemme 4 verschraubt und müssen selbst bei einem Wechsel des Elektrizitätszählers nicht gelöst werden.

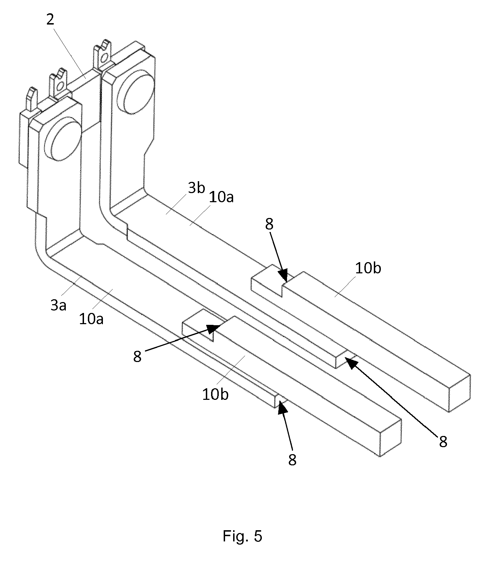

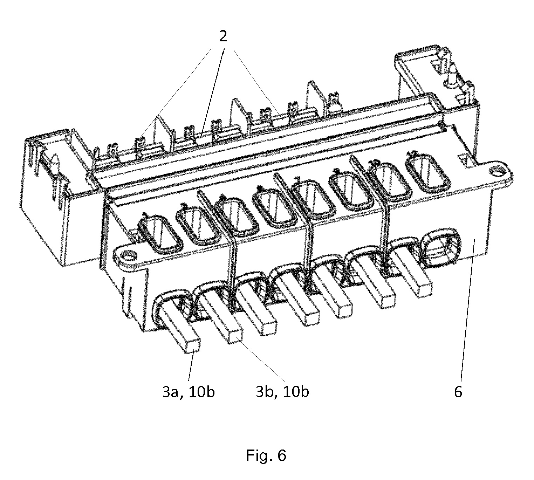

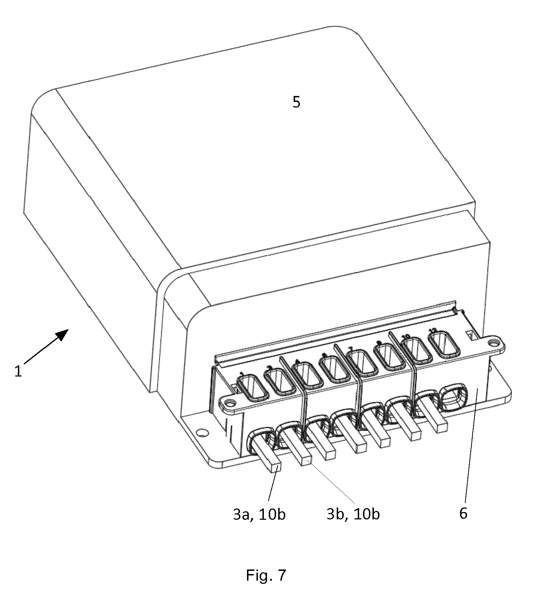

Fig. 5 zeigt in einer perspektivischen Darstellung eine Ausführungsform der Leiter 3a, 3b des erfindungsgemässen Elektrizitätszählers 1, wobei diese Leiter 3a, 3b zweiteilig aufgebaut sind. Ein erster Teilleiter 10a der Leiter 3a, 3b ist an der Strom-Spannungsmesseinheit 2 angeordnet und ein zweiter Teilleiter 10b der Leiter 3a, 3b ist jeweils als ein viereckiger Zähleranschlussstift ausgeführt, der unmittelbar mit dem jeweiligen ersten Teilleiter 10a verbunden ist. Die Leiter 3a, 3b weisen vorliegend -hier so bezeichnete- Leitersprünge 8, die, wie im Folgenden noch zu zeigen sein wird, formschlüssige Verbindungen mit Gehäusewandungen 11 des Klemmenblockgehäuseteils 6 und/oder des Zählergehäuses 5 eingehen, zwecks Abstützung der Leiter 3a, 3b. In Fig. 6 ist die perspektivische Darstellung des Klemmenblockgehäuseteils 6 mit viereckigen zweiten Teilleitern 10b der Leiter 3a, 3b gezeigt und in Fig. 7 ist dieser Klemmenblockgehäuseteil 6 an dem erfindungsgemässen Elektrizitätszähler 1 angeordnet dargestellt.

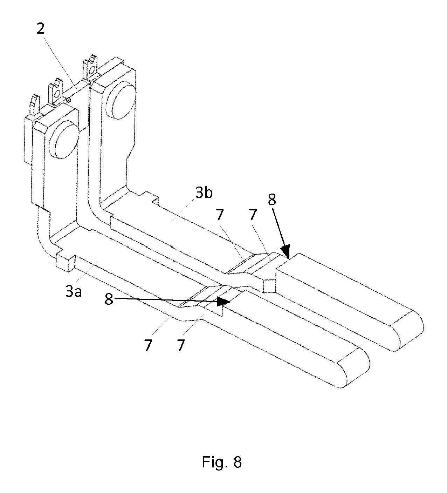

Die perspektivische Darstellung in Fig. 8 zeigt die als reine Stanzteile ausgeführten Leiter 3a, 3b, bei denen die der Strom-Spannungsmesseinheit 2 abgewandten Enden der Leiter 3a, 3b einen vergrösserten Querschnitt aufweisen.

Die Querschnittdarstellung in Fig. 9 zeigt einen Schnitt durch das Klemmenblockgehäuseteil 6 und einen Leiter 3a, umfassend den ersten Teilleiter 10a und den zweiten Teilleiter 10b. Wie bereits in der Beschreibung zur Fig. 2 erwähnt wurde, verdeutlicht die Schnittdarstellung in Fig. 9 die Ausführung des Leiters 3a, welcher auf der einen Seite unmittelbar mit der Strom-Spannungsmesseinheit 2 verbunden ist und auf der dieser Strom-Spannungsmesseinheit 2 abgewandten Seite vollständig durch das Klemmenblockgehäuseteil 6 hindurchführt ist und diesen überragt, siehe Fig. 2, zwecks direkter Anschlussmöglichkeit an eine Zählersteckklemme 4. Der zweite Teilleiter 10b weist vorliegend eine Nut 9 auf, in welche eine Wandung 11 des Klemmenblockgehäuseteils 6 formschlüssig eingreift. Diese formschlüssige Verbindung zwischen der Gehäusewandung 11 und dem zweiten Teilleiter 10b positioniert und fixiert den Leiter 3a an der vorgesehenen Stelle. Somit werden mechanische Kräfte, die auf den Leiter 3a beispielsweise bei der Montage oder Demontage einwirken, auf diese Gehäusewandung 11 umgelenkt und ein Verschieben des Leiters 3a verhindert. Auch die mechanischen Kräfte, die im Betrieb des Elektrizitätszählers 1 aufgrund von Stromwärme auftreten, werden durch diese Gehäusewandung 11 aufgefangen. Durch diese formschlüssige Verbindung (9, 11) zwischen dem Leiter 3a und der Gehäusewandung 11 bleibt die Strom-Spannungsmesseinheit 2 vollkommen frei von jeder mechanischen Krafteinwirkung, sowohl bei der Montage als auch im Betrieb. Selbstredend dient die anhand des Leiters 3a gezeigte, formschlüssige Verbindung zwischen diesem Leiter 3a und der Gehäusewandung 11 lediglich als Beispiel und ist ebenso auf den Leiter 3b anwendbar.

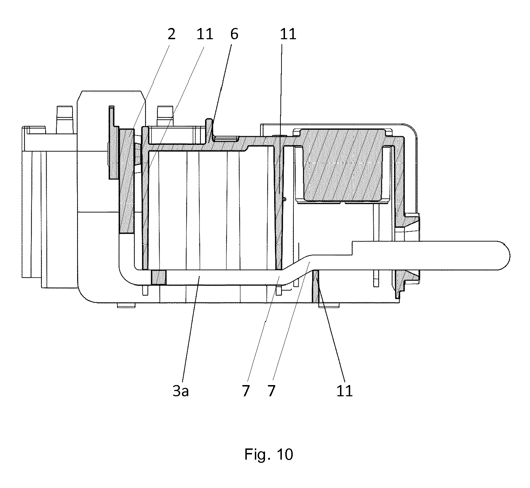

Fig. 10 zeigt eine weitere Schnittdarstellung des Klemmenblockgehäuseteils 6 und des Leiters 3a. In der Beschreibung zur Fig. 3 wurde bereits darauf hingewiesen, dass der Leiter 3a Biegestellen 7 aufweist, die -wie vorliegend Fig. 10 erhellt-formschlüssig mit Gehäusewandungen 11 des Klemmenblockgehäuseteils 6 derart zusammenwirken, dass der Leiter 3a an dieser Stelle positioniert und fixiert wird. Ferner weist die Strom-Spannungsmesseinheit 2 ebenfalls eine formschlüssige Berührung mit einer Gehäusewandung 11 es Klemmenblockgehäuseteils 6 auf. Die Funktion der hier in Rede stehenden formschlüssigen Verbindung mit Gehäusewandungen 11 und dem Leiter 3a bzw. der Strom-Spannungsmesseinheit 2 ist in Analogie zur Beschreibung zur Fig. 9 zu sehen; demzufolge erübrigt sich eine weitere Ausführung dazu.

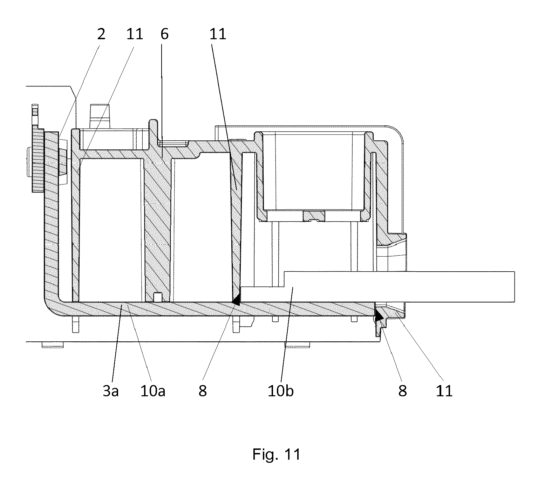

Die Querschnittdarstellung in Fig. 11 zeigt eine weitere Ausführungsform formschlüssiger Verbindungen zwischen dem Leiter 3a bzw. dem ersten und zweiten Teilleiter 10a, 10b mit Gehäusewandungen 11 des Klemmenblockgehäuseteils 6. An hier so bezeichneten Leitersprüngen 8 des ersten Teilleiters 10a und des zweiten Teilleiters 10b greifen Gehäusewandungen 11 des Klemmenblockgehäuseteils 6 formschlüssig an, um den Leiter 3a zu positionieren und zu fixieren, wie bereits funktinoal in der Beschreibung zu Fig. 9 hinreichend erläutert.

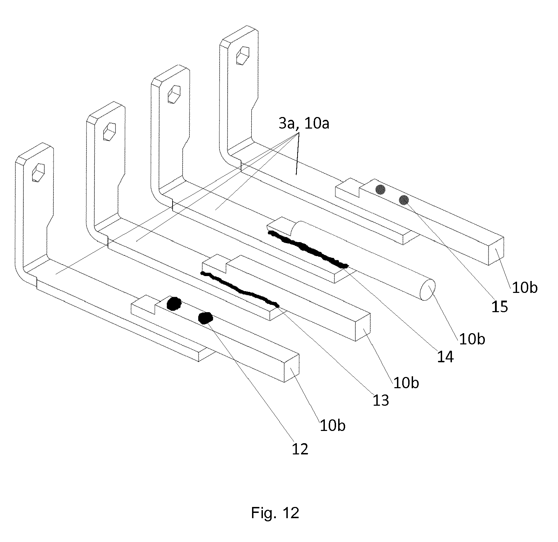

In Fig. 12 sind eine Anzahl möglicher Ausführungsformen für die Teilleiter 10a, 10b perspektivisch dargestellt. Hierbei ist mit 12 eine Nietverbindung zwischen dem ersten und dem zweiten Teilleiter 10a, 10b dargestellt, mit 13 eine Lötverbindung, mit 14 eine Schweissverbindung und mit 15 eine Schraubverbindung. Zudem wird anhand der Fig. 12 deutlich, dass zweite Teilleiter 10b auch als runde Zähleranschlussstifte ausgeführt sein können, wie bei der Schweissverbindung 14 gezeigt.

### Bezugszeichenliste

- 1: Elektrizitätszähler
- 2: Strom-Spannungsmesseinheit
- 3a, b: Leiter an 2
- 4: Zählersteckklemme
- 5: Zählergehäuse
- 6: Klemmenblockgehäuseteil
- 7: Biegestelle
- 8: Leitersprung
- 9: Nut
- 10a, b: Teilleiter von 3a, 3b
- 11: Gehäusewandung
- 12: Nietverbindung
- 13: Lötverbindung
- 14: Schweissverbindung
- 15: Schraubverbindung

## Patentansprüche

1. Elektrizitätszähler (1), der mit mindestens einer Strom-Spannungsmesseinheit (2) und daran unmittelbar angeschlossenen, elektrischen Leitern (3a, 3b) ausgestattet ist, wobei die Strom-Spannungsmesseinheit (2) mit den elektrischen Leitern (3a, 3b) in einem Zählergehäuse (5) angeordnet sind und sich die Leiter (3a, 3b) bis zu einem an dem Zählergehäuse (5) angeordneten Klemmenblockgehäuseteil (6) erstrecken, **dadurch gekennzeichnet, dass** die mit der Strom-Spannungsmesseinheit (2) unmittelbar verbundenen Leiter (3a, 3b) vollständig durch das Klemmenblockgehäuseteil (6) hindurchragen und dieses überragen, zwecks eines direkten Anschlusses der Leiter (3a, 3b) an einer Zählersteckklemme (4) einer Hausinstallation.

2. Elektrizitätszähler nach Anspruch 1, **dadurch gekennzeichnet, dass** die unmittelbar mit der Strom-Spannungsmesseinheit (2) verbundenen Leiter (3a, 3b) als Stanzteile gefertigt sind.

3. Elektrizitätszähler nach Anspruch 1, **dadurch gekennzeichnet, dass** die unmittelbar mit der Strom-Spannungsmesseinheit (2) verbundenen Leiter (3a, 3b) als Stanz-Biegeteile gefertigt sind, wobei die Leiter (3a, 3b) an ihren der Strom-Spannungsmesseinheit (2) abgewandten Enden umgebogen sind.

4. Elektrizitätszähler nach einem der Ansprüche 1 oder 2, **dadurch gekennzeichnet, dass** jeder einzelne Leiter (3a, 3b) aus einem ersten und einem zweiten Teilleiter (10a, 10b) ausgebildet ist, wobei der erste Teilleiter (10a) als Stanzteil gefertigt ist und der zweite Teilleiter (10b) als ein Zähleranschlussstift an dem ersten Teilleiter (10a) angelötet, angeschweisst, angenietet oder angeschraubt ist.

5. Elektrizitätszähler nach Anspruch 4, **dadurch gekennzeichnet, dass** der zweite Teilleiter (10b) einen runden oder einen viereckigen Querschnitt aufweist.

6. Elektrizitätszähler nach einem der Ansprüche 1 bis 5, **dadurch gekennzeichnet, dass** die Leiter (3a, 3b) mindestens eine Biegestelle (7), einen Leitersprung (8) und/oder eine Nut (9) aufweisen, wobei diese Biegestelle (7), dieser Leitersprung (8) und/oder diese Nut (9) zwecks Aufnahme mechanischer Kräfte formschlüssig an einer Gehäusewandung (11) des Zählergehäuses (5) bzw. des Klemmenblockgehäuseteils (6) abstützbar angeordnet ist.
